Europäisches Patentamt

European Patent Office

Office européen des brevets

(11) Veröffentlichungsnummer : **0 181 537 B1**

# (12) EUROPÄISCHE PATENTSCHRIFT

(45) Veröffentlichungstag der Patentschrift :
**23.01.91 Patentblatt 91/04**

(51) Int. Cl.⁵ : **G11B 31/00, G11B 19/02, H04B 1/20, H03J 9/00, // G11B15/02**

(21) Anmeldenummer : **85113434.6**

(22) Anmeldetag : **23.10.85**

(54) Anordnung der Unterhaltungselektronik mit einer in eine Vielzahl unterschiedlicher Betriebseinstellungen einstellbaren Steuerschaltung.

(30) Priorität : **27.10.84 DE 3439398**

(43) Veröffentlichungstag der Anmeldung :
**21.05.86 Patentblatt 86/21**

(45) Bekanntmachung des Hinweises auf die Patenterteilung :
**23.01.91 Patentblatt 91/04**

(84) Benannte Vertragsstaaten :
**DE FR GB IT NL**

(56) Entgegenhaltungen :
**EP-A- 0 103 707**
**WO-A-81/03713**
**FR-A- 2 441 310**
**US-A- 3 711 691**
**US-A- 4 337 480**
**PATENT ABSTRACTS OF JAPAN, Band 9, Nr. 27 (E-294)[1750], 6. Februar 1985; & JP-A-59 171 397 (SONY K.K.) 27-09-1984**

(56) Entgegenhaltungen :
**PATENT ABSTRACTS OF JAPAN, Band 9, Nr. 27 (E-294)[1750], 6. Februar 1985; & JP-A-59 171 398 (SONY K.K.) 27-09-1984**
**PATENT ABSTRACTS OF JAPAN, Band 6. Nr. 47 (E-99)[925], 26. März 1982; & JP-A-56 161 792 (TOKYO SHIBAURA DENKI K.K.) 12-12-1981**
**PATENT ABSTRACTS OF JAPAN, Band 6, Nr. 125 (P-127)[1003], 10. Juli 1982; & JP-A-57 50 370 (MATSUSHITA DENKI SANGYO K.K.) 24-03-1982**

(73) Patentinhaber : **Nokia Unterhaltungselektronik (Deutschland) GmbH**
**Östliche Karl-Friedrich-Strasse 132**
**D-7530 Pforzheim (DE)**

(72) Erfinder : **Apitz, Siegfried**
**L. Windthorststrasse 24**
**D-7530 Pforzheim (DE)**
Erfinder : **Durst, Klaus**
**Odenwaldstrasse 15**
**D-7520 Bruchsal (DE)**
Erfinder : **Müller, Helmut**
**Riedstrasse 32**
**D-7530 Pforzheim (DE)**

EP 0 181 537 B1

## Beschreibung

Die Erfindung betrifft eine Empfangs-, Aufnahme- oder Wiedergabeanordnung der Unterhaltungselektronik der im Oberbegriff des Anspruches 1 angegebenen Art.

Videorecordergeräte zur Aufnahme von Fernsehsendungen auf einen Aufzeichnungsträger, aus einem Videorecorder und einem Fernsehgerät bestehende Geräteanordnungen zur Wiedergabe einer auf dem Aufzeichnungsträger des Videorecorders befindlichen Fernsehaufzeichnung oder auch vorprogrammierbare Fernsehempfangsgeräte weisen heute schon eine Vielzahl unterschiedlicher Betriebsabläufe auf, in die sie eingestellt werden können, beispielsweise die Aufnahme einer Fernsehsendung auf einen Aufzeichnungsträger, die Wiedergabe der aufgezeichneten Videosendung, die Wiedergabe der gerade empfangenen Sendung, die Einprogrammierung eines Programmwunsches, die speichermäßige Zuordnung eines Empfangskanales zu einer ein Senderprogramm kennzeichnenden Programmnummer, den Betriebsablauf für die Einstellung einer für die Programmüberwachung erforderlichen Uhr oder den langsamen oder schnellen Vor- oder Rücklauf eines Videorecorders. Für die Wahl der die Betriebsabläufe steuernden Betriebseinstellungen dieser Geräte und zur Eingabe der Einstelldaten während einiger dieser Betriebsabläufe ist eine Vielzahl von Einstellelementen an den Geräten und Anordnungen erforderlich. Beispielsweise ist aus dem JVC-Service-Manual Nr. 8214 der Victor Company of Japan ein Videorecorder HR-7600EG bekannt, der zwölf Speicherplätze für empfangbare Senderprogramme enthält. Jedem Speicherplatz ist eine Programmtaste zugeordnet, mit dem der Speicherplatz aufrufbar ist. Die Einspeicherung der an Wahlschaltern und Reglern eingestellten Abstimmdaten auf einen bestimmten Sender erfolgt durch einen Tastendruck auf den Einstellregler. Zur Einspeicherung eines Programmwunsches muß an dem bekannten Gerät eine Programmeinstelltaste betätigt werden, die die Grundbetriebseinstellung (Uhrbetrieb) der Steuerschaltung des bekannten Gerätes in die Programmiereinstellung der Steuerschaltung umschaltet. In dieser Betriebseinstellung ist die erste Programmzeile für den Programmwunsch in der Datenschaltung des bekannten Videorecorders eingestellt. Wird eine andere Programmzeile gewünscht, muß eine Programmnummertaste des Gerätes betätigt werden. Danach ist eine Einstelltaste zu betätigen, bis die Programmnummer aufleuchtet, deren gespeicherter Sender aufgenommen werden soll. Danach ist eine Wahltaste zu betätigen, um den nächsten Datenwortplatz der Programmzeile anzuwählen. Durch Betätigen der Einstelltaste wird ein Datenwortangebot eines Datenwortspeichers zum Ablauf gebracht, bis das gewünschte Datenwort auf dem Display sichtbar ist. Durch Betätigen der Auswahltaste wird somit sequentiell von Datenwortplatz zu Datenwortplatz der mit der Programmnummertaste ausgewählten Programmzeile weitergeschaltet und durch Betätigen der Einstelltaste das entsprechende Datenwort aus dem Datenwortangebot des zugehörigen Datenwortspeichers ausgewählt. Nach Beendigung der Einspeicherung des Programmwunsches muß die Uhrtaste betätigt werden, um die Steuerschaltung des bekannten Gerätes in den Grundbetriebszustand zurückzuschalten. Die Eingabehandlungen in anderen Betriebseinstellungen des Gerätes erfolgen in ähnlicher Weise. Aus dieser Aufzählung ist ersichtlich, daß die Einstellung eines derartigen Gerätes und insbesondere die Eingabe eines Programmwunsches in ein derartiges Gerät eine aufwendige Handhabung darstellt, die von einem Benutzer, der das Gerät nur zeitweise handhabt, ohne jeweils vorheriges Befragen der Bedienungsanleitung kaum zu bewältigen ist. Eine derartige Handhabung ist somit umständlich und wird vom Benutzer ungern ausgeführt.

Der Erfindung liegt die Aufgabe zugrunde, eine Anordnung der im Oberbegriff des Anspruches 1 angegebenen Art derart auszubilden, daß die Einstellung einer gewünschten Betriebseinstellung der Anordnung und die in einer ausgewählten Programmierbetriebseinstellung erforderliche Dateneingabe die Betätigung nur weniger, möglichst nur zweier Tastschalter erfordert und daß der Bedienungsablauf stets in der gleichen Ablaufweise erfolgt. Diese Aufgabe wird nach der Erfindung durch die im kennzeichnenden Teil des Anspruches 1 angegebenen Maßnahmen gelöst.

Die Erfindung weist den Vorteil auf, daß ein Tastschalter zur Auswahl einer bestimmten Betriebseinstellung der Anordnung nicht nur zur Einstellung der gewünschten Betriebseinstellung vorgesehen ist, sondern dann wenn diese Betriebseinstellung in der Steuerschaltung der Anordnung eingestellt ist und diese Betriebseinstellung eine Programmierbetriebseinstellung ist, bei der darauf folgenden Betätigung zur Anwahl der Programmzeilen und nach der erstmaligen Betätigung des Eingabetastschalters zur sequentiellen Auswahl der Datenwortplätze in dieser Programmzeile benutzt wird. Der Auswahltastschalter für eine Programmiereinstellung des Gerätes beinhaltet somit gleichzeitig ein Bedienungselement zur Auswahl der gewünschten Programmzeile in der eingestellten Programmierbetriebseinstellung und außerdem ein Bedienungselement zur sequentiellen Anwahl des jeweiligen Datenwortplatzes, in den die mit dem Einstelltastschalter angewählten Programmworte eingespeichert werden sollen. Da für sämtliche anwählbaren Programmierbetriebseinstellungen der Steuerschaltung der Anordnung der gleiche Anwahl- und Eingabeablauf für die Programmierung vorgesehen ist, und der Benutzer der Anordnung hierbei nur zwei Tasten bedienen muß, nämlich die Auswahltaste für die Programmierbetriebseinstellung und den Eingabeschalter, liegt für den Benutzer ein einfach erlernbarer und merkbarer Einstell- und Bedienungsablauf vor.

Die Unteransprüche kennzeichnen vorteilhafte Ausgestaltungen und Weiterbildungen der Erfindung, die die Einstellung und Bedienung der Anordnung für den Benutzer noch weiter vereinfachen.

Die Erfindung wird nachfolgend anhand vorteilhafter Ausführungsbeispiele näher erläutert. In der Zeichnung zeigen

Figur 1 ein Blockschaltbild des Programmierungsteiles eines Videorecorders,

Figur 2 eine schematische Darstellung eines Bedienungsablaufes zur Einstellung verschiedener Betriebseinstellungen und zur Programmierung in einigen dieser Einstellungen eines Gerätes nach Figur 1,

Figur 3 die schematische Darstellung eines Ausschnittes eines Bedienungsfeldes eines Gerätes nach Figur 1.

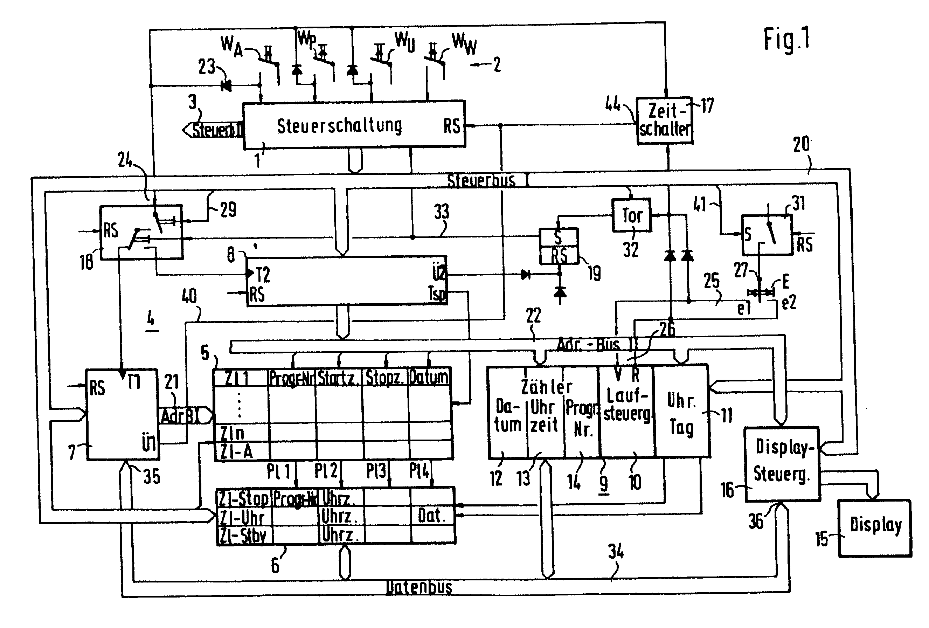

In Figur 1 ist schematisch der Schaltungsteil für die Programmierung eines Videorecorders als ein Beispiel einer Empfangs-, Aufnahme- oder Wiedergabeanordnung der Unterhaltungselektronik in einem Blockschaltbild dargestellt. Dieser Schaltungsteil enthält eine Steuerschaltung 1,deren Betriebseinstellung von Auswahltastschaltern 2 eingestellt werden kann. In der Zeichnung sind beispielsweise ein Auswahltastschalter $W_A$ für die Betriebseinstellung BE III "Aufnahme" der Steuerschaltung, ein Auswahltastschalter $W_P$ zur Einstellung des Betriebszustandes BE V "Programmwunschprogrammierung" der Steuerschaltung, ein Auswahltastschalter $W_U$ für die Betriebseinstellung "Zeitprogrammierung" und ein Auswahltastschalter $W_W$ für die Betriebseinstellung "Wiedergabe" der Steuerschaltung dargestellt. In einer der durch die Auswahltastschalter 2 eingestellten Betriebseinstellung der Steuerschaltung 1 steuert die Steuerschaltung über einen Steuerbus (II) 3 den zugehörigen Betriebsablauf des Gerätes in hier nicht näher dargestellter Weise. Unter den auswählbaren Betriebseinstellungen der Steuerschaltung 1 befinden sich auch solche, in denen durch Eingabe von Daten in bestimmte Programmspeicher Programmiervorgänge durchgeführt werden können. Derartige Betriebseinstellungen der Steuerschaltung 1 werden hier mit Programmierbetriebseinstellungen bezeichnet.

Die für die Programmierung vorgesehene Schaltung des Videorecorders umfaßt eine Datenschaltung 4, die einen ersten Programmspeicher 5 und einen zweiten Programmspeicher 6, einen Zeilenadresszähler 7 und einen Wortplatzzähler 8 enthält, einen Datenwortgeber 9, der im dargestellten Ausführungsbeispiel aus einer Laufsteuerung 10, einer Jahresuhr 11, sowie voreinstellbaren Wortzählern 12, 13 und 14 mit einem Datenwortangebot für Datum, Uhrzeit und Programmnummern besteht, eine Anzeigevorrichtung 15 mit einer zugehörigen Anzeigesteuerung 16, eine Zeitschalteranordnung 17 und eine Umschaltanordnung 18 mit einer zugehörigen Zustandsspeicherschaltung 19. Diese Schaltungen sind über einen zweiten Steuerbus 20 mit der Steuerschaltung 1 verbunden und werden von dieser über den Steuerbus 20 gesteuert. Zur Auswahl der Programmzeilen ZI1 bis ZIn ist der erste Programmspeicher 5 über einen Adressenbus 21 mit dem Zeilenadresszähler 7 verbunden. Die Zeilen des zweiten Programmspeichers 6 und die Zeile ZI-A des ersten Programmspeichers 5 werden direkt über den Adressenbus 20 angewählt. Die Programmzeilen des ersten Programmspeichers 5 und des zweiten Programmspeichers 6 enthalten vier anwählbare Datenwortplätze PI1 bis PI4, die über einen zweiten Adressenbus 22 vom Wortplatzzähler 8 angewählt werden. Gleichzeitig mit den Datenwortplätzen werden vom Wortplatzzähler 8 über den zweiten Adressenbus 22 die zugehörigen Wortzähler 12, 13 oder 14 oder die Jahresuhr 11 des Datenwortgebers angewählt sowie über die Anzeigesteuerung 16 die Anzeige des angewählten Datenwortplatzes angesteuert.

Die Auswahltastschalter, z.B. $W_A$, $W_P$, $W_U$, zur Einstellung einer Programmierbetriebseinstellung der Steuerschaltung 1 sind entweder direkt über Entkopplungsdioden 23 oder mittelbar über die Steuerschaltung 1 mit dem Signaleingang 24 der Umschaltanordnung 18 verbunden. Ein Eingabetastschalter E enthält neben einer Mittenstellung zwei Betätigungsstellungen e1 und e2, mit denen der Eingang 27 des Eingabetastschalters E mit den Eingängen V und R des Fortschaltsteuereingangs 26 des Datenwortgebers 9 verbundden ist.

Außerdem entält die Anordnung einen Datenbus 34, an dem die Programmspeicher 5 und 6 und der Datenwortgeber 9 in Eingaberichtung und Ausgaberichtung angeschlossen sind und an den ein Dateneingang 35 des Zeilenadresszählers 7 und ein Dateneingang 36 der Anzeigesteuerung 16 angeschlossen sind.

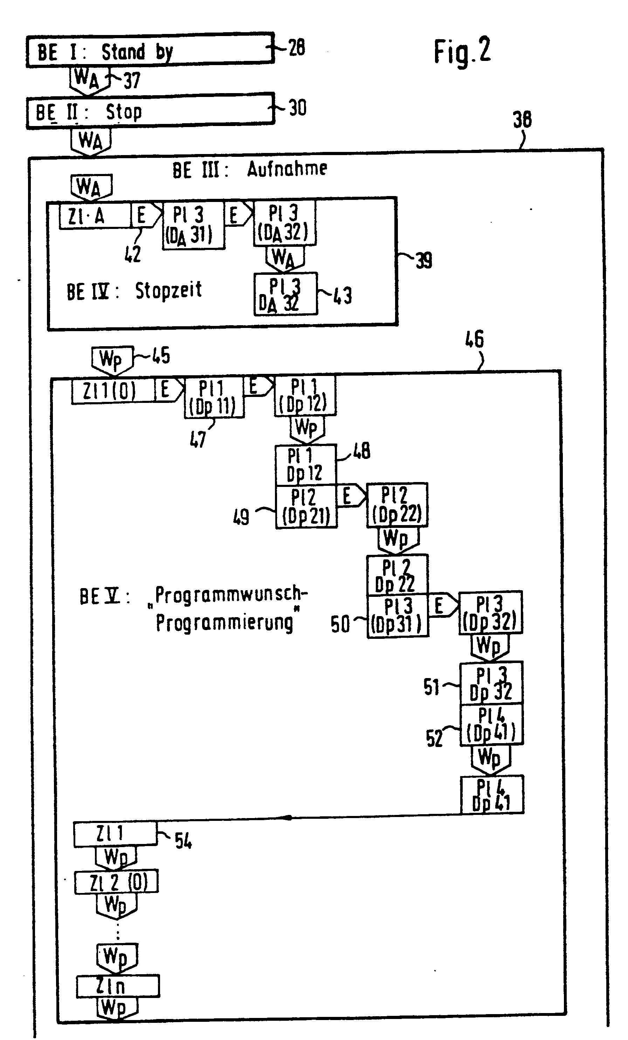

Anhand des in Figur 2 schematisch dargestellten Bedienungsablaufes wird nachfolgend die Einstellung verschiedener Betriebseinstellungen der Steuerschaltung 1 und die dadurch von der Steuerschaltung gesteuerten zugehörigen Betriebsabläufe näher erläutert. Im dargestellten Ausführungsbeispiel befindet sich die Anordnung zunächst in der Betriebseinstellung BEI "Stand by", die in Figur 2 schematisch durch die Umrandung 28 dargestellt ist. Um den Aufnahmebetrieb des Videorecorders einzustellen, betätigt ein Benutzer des Gerätes den Auswahltastschalter $W_A$ "Aufnahme". Die Betätigung des Auswahltastschalters $W_A$ ist in der Figur 2 schematisch durch das Hinweiskästchen 37 dargestellt. Das mit der Betätigung des Auswahltastschalters $W_A$

erzeugte Schaltsignal schaltet die Steuerschaltung 1 im dargestellten Ausführungsbeispiel in eine Betriebseinstellung BE II "Stop", die schematisch durch die Umrandung 30 dargestellt ist. Mit dieser Zwischeneinstellung wird die Gefahr beseitigt, daß das Gerät versehentlich durch eine unbeabsichtigte Tastenbestätigung in einen nicht gewünschten Betriebsablauf geschaltet wird. Zur Einstellung der Steuerschaltung 1 in die gewünschte Betriebseinstellung BE III "Aufnahme", die durch die Umrandung 38 schematisch dargestellt ist, ist eine weitere Betätigung des Auswahltastschalters $W_A$ erforderlich. In dieser Betriebseinstellung steuert die Steuerschaltung 1 den Betriebsablauf des Aufnahmebetriebes des Gerätes über den Steuerbus 3. Gleichzeitig ist mit dieser Betriebseinstellung eine weitere Betriebseinstellung BE IV "Stopzeit" so vorbereitet, daß eine neuerliche Betätigung des Auswahltastschalters $W_A$ diese Betriebseinstellung BE IV, die durch die Umrandung 39 in der Figur 2 schematisch dargestellt ist, zusätzlich zu der bereits bestehenden Betriebseinstellung BE III in der Steuerschaltung 1 einschaltet. In dieser Betriebseinstellung wird über den Steuerbus 20 die Programmzeile ZI-A des Programmspeichers 5 angewählt, die Anzeigesteuerung 16 so angesteuert, daß die Anzeigevorrichtung 15 den Inhalt dieser Programmzeile anzeigt, und der Wortplatzzähler 8 so gesetzt daß er in der angewählten Programmzeile den Datenwortplatz PI3 für die Stopzeit anwählt. Außerdem wird über eine Leitung 29 des Steuerbus 20 die Umschaltanordnung 18 in die erste Schaltstellung gesetzt, in der sie ihren Signaleingang 24 mit einem ersten Takteingang T1 der Datenschaltung 4 verbindet, nämlich dem Takteingang des Zeilenadresszählers 7. Der Zeilenadresszähler 7 ist in der Betriebseinstellung BE IV der Steuerschaltung 1 so gesetzt, daß bei einer neuerlichen Betätigung des Auswahltastschalters $W_A$ von dem von diesem erzeugten Schaltsignal, das über die Umschaltanordnung 18 an den Takteingang T1 gelangt, in den Überlaufzustand gesetzt wird. In diesem Zustand erzeugt der Zeilenadresszähler 7 an seinem Überlaufausgang Ü1 ein Überlaufsignal, das über eine Leitung 40 an einen Rückstelleingang RS der Steuerschaltung 1 gelangt und den eingestellten Programmierbetriebszustand BE IV ausschaltet.

Wird statt des Auswahltastschalters $W_A$ der Eingabetastschalter E betätigt, der durch die gesetzte Schaltanordnung 31 wirksam geschaltet ist, wird dadurch die Zustandsspeicherschaltung 19 der Umschaltanordnung 18 über eine Torschaltung 32 in den Setzzustand gesetzt. In diesem Zustand ist die Umschaltanordnung 18 in die zweite Schaltstellung gesetzt, in der sie nunmehr den Signaleingang 24 der Umschaltanordnung mit dem zweiten Takteingang T2 der Datenschaltung 4, nämlich den Takteingang des Wortplatzzählers 8 verbindet. Die Schaltanordnung 31 zur Einschaltung des Eingabetastschalters E wird über eine Leitung 41 des Steuerbusses 20 mit der Rückflanke des gleichen Schaltsignales in die wirksame Schaltstellung gesetzt wie die Umschaltanordnung 18 in die erste Schaltstellung, nämlich mit der Rückflanke des Schaltsignales, das durch Betätigen des Auswahltastschalters $W_A$ die Steuerschaltung 1 in die Betriebseinstellung BE IV "Stopzeit" setzt. Jede Betätigung des Eingabetastschalters E ist in der Figur 2 durch ein nach rechts gerichtetes Hinweiskästchen 42 schematisch dargestellt.

Mit der ersten Betätigung des Eingabetastschalters E wurde gleichzeitig der Wortzähler 13 für die Uhrzeit des Datenwortgebers 9 auf die Zeitangabe der im Datenwortplatz PI 2 der angewählten Programmzeile ZI-A gespeicherten Standzeit gesetzt und diese Zeitangabe $D_A31$ in der Anzeigevorrichtung 15 als Stopzeit angezeigt. Über den zweiten Adressbus 22 ist vom Wortplatzzähler 8 dieser Wortzähler 13 für die Uhrzeit aufgerufen und in der Anzeigevorrichtung 15 die zu programmierende Stelle besonders kenntlich gemacht. Ein weiteres Betätigen des Eingabetastschalters E setzt je nach Betätigungsrichtung die Laufsteuerung 10 des Datenwortgebers 9 in Vorwärts- oder Rückwärtsrichtung in Lauf und damit auch den Wortzähler 13 für die Uhrzeit. Der Eingabetastschalter E wird so lange betätigt, bis die Anzeigevorrichtung 15 die gewünschte Stopzeit $D_A32$ anzeigt. Als weiterer Bedienungsschritt wird nun wieder der Auswahltastschalter $W_A$ betätigt. Das dadurch erzeugte Schaltsignal gelangt an den Takteingang T2 des Wortplatzzählers 8 und erzeugt im dargestellten Ausführungsbeispiel zunächst in diesem an einen Speichertaktausgang $T_{SP}$ ein Einspeichersignal, das zum Programmspeicher 5 gelangt und im angewählten Datenwortplatz PI3 der angewählten Programmzeile ZI-A den anliegenden Zeitwert $D_A32$ einspeichert. Dieser Vorgang ist in Figur 2 dadurch dargestellt, daß in der den Datenwortplatz PI3 schematisch darstellenden Umrandung 43 der Zeitwert $D_A32$ ohne Klammern dargestellt ist. Außerdem wird der Wortplatzzähler 8 durch das Schaltsignal an seinem Takteingang T2 in die Überlaufstellung fortgeschaltet, in der er an seinem Überlaufausgang Ü2 ein Überlaufsignal erzeugt. Dieses Überlaufsignal gelangt an den Rückstelleingang RS der Zustandsspeicherschaltung 19 und setzt damit die Umschaltanordnnung 18 in die erste Schaltstellung zurück, in der sie ihren Signaleingang 24 mit dem ersten Takteingang T1 der Datenschaltung verbindet. Gleichzeitig wird damit auch der Wortplatzzähler 8 zurückgestellt. Ein erneutes Betätigen des Auswahltastschalters $W_A$ schaltet in der zuvor beschriebenen Weise die Betriebseinstellung BE IV "Stopzeit" aus. Wird jedoch der Auswahltastschalter $W_A$ nicht mehr betätigt, wird die in der Steuerschaltung 1 eingestellte Programmierbetriebseinstellung BE IV durch ein Ausgangssignal des Zeitschalters 17 ausgeschaltet, das an den Rückstelleingang RS der Steuerschaltung gelangt. Mit jeder Betätigung des Eingabetastschalters oder einer Auswahltastschalter 2, die eine Programmierbetriebseinstellung in der Steuerschaltung 1 aufrufen, wird nämlich der Zeitschalter 17 eingeschaltet, der nach einer vorgegebenen Zeitspanne von beispielsweise zwei Minuten an seinem Ausgang 44 ein Ausgangssignal zu Ausschalten einer in der Steuerschaltung 1 eingestellten Programmierbetriebseinstellungen erzeugt.

Während des weiteren Ablaufes des Aufnahmebetriebes des Videogerätes kann beim dargestellten Ausführungsbeispiel ein Programmwunsch in den Programmspeicher 5 einprogrammiert werden. Dazu wird der Auswahltastschalter $W_P$ betätigt, was in Figur 2 durch das nach unten gerichtete Hinweiskästchen 45 schematisch dargestellt. In der Steuerschaltung 1 wird dadurch neben der dort eingestellten Betriebseinstellung BEIII "Aufnahme" zusätzlich die Programmierbetriebseinstellung BEV "Programmwunsch-Programmierung" eingestellt, die in Figur 2 durch die Umrandung 46 schematisch dargestellt ist. In der gleichen Weise wie zuvor geschildert, wird die Umschaltanordnung 18 in die erste Schaltstellung gesetzt und der Eingabetastschalter durch Setzen der Schaltanordnung 31 wirksam geschaltet. Gleichzeitig wird im Adresszähler 7 über dem Steuerbus 20 ein Suchlauf aufgerufen, mittels den über den Datenbus 34 eine leere Programmzeile des Programmspeichers 5 gesucht und über den ersten Adressbus 21 adressiert wird.

Diese Programmzeile ist in der Umrandung 46 der Figur 2 durch die Umrandung mit der Bezeichnung ZI1(0) dargestellt. Der Wortplatzzähler 8 ist so gesetzt, daß er über den zweiten Adressbus 22 den ersten Datenwortplatz PI1 der angewählten leeren Programmzeile ZI1(0) angewählt hat und im Datenwortgeber 9 den Wortzähler 14 für die Programmnummer aufgerufen hat. Bei einer neuerlichen Betätigung des Auswahltastschalters $W_P$ gelangt ein dadurch erzeugtes Schaltsignal an den Takteingang T1 des Zeilenadresszählers 7, das den Zeilenadresszähler um einen Schritt fortschaltet auf die Adresse der ersten Programmierten Programmzeile. Wird anstelle des Auswahltastschalters $W_P$ der Eingabetastschalter E betätigt, wie es in der Umrandung 46 der Figur 2 angegeben ist, wird die Umschaltanordnung 18 in der bereits beschriebenen Weise in die zweite Schaltstellung gesetzt, in der sie den Signaleingang 24 mit dem zweiten Takteingang T2 der Datenschaltung 4 verbindet. In dieser Einstellung wird in der Anzeigevorrichtung 15 beispielsweise die erste wählbare Programmnummer angezeigt, was durch die in Klammer stehende Bezeichnung $D_P11$ im Kästchen 47 für den Datenwortplatz PI1 schematisch dargestellt ist. Auf diese Programmnummer wird auch der Wortzähler 14 für die Programmnummer gesetzt. Durch ein erneutes Betätigen des Eingabetastschalters E wird die gewünschte Programmnummer in der gleichen Weise eingestellt, wie sie bereits für die Einstellung der Stopzeit beschrieben wurde. Das Schaltsignal des darauffolgend erneut betätigten Auswahltastschalters $W_P$ löst in der beschriebenen Weise ein Einspeichersignal am Ausgang $T_{SP}$ des Wortplatzzählers 8 aus, wodurch die eingestellte Programmnummer $D_P12$ in den Datenwortplatz PI1 eingespeichert wird (Kästchen 48) und der Wortplatzzähler um einen Schritt weitergeschaltet wird, zur Anwahl des Datenwortplatzes PI2 der angewählten Programmzeile ZI1(0) und zum Aufruf des Wortzählers 13 für die Uhrzeit im Datenwortgeber 9. Der Uhrzeitzähler wird im dargestellten Ausführungsbeispiel auf die tatsächliche Uhrzeit $D_P21$ gesetzt und dies in der Anzeigevorrichtung 15 angezeigt. Die durch die zweite Zählerstellung des Wortplatzzählers 8 aufgerufenen Einstellungen sind mit dem Kästchen 49 in Figur 2 schematisch dargestellt. Mit einer erneuten Betätigung des Eingabetastschalters E wird die angegebene Startzeit $D_P22$ für den ausgewählten Programmwunsch am Wortzähler 13 für die Uhrzeit eingestellt und mit einer erneuten Betätigung des Auswahltastschalters $W_P$ in den Datenwortplatz PI2 eingespeichert. Gleichzeitig ist damit der Datenwortplatz PI3 der angewählten Programmzeile angewählt und weiterhin der Wortzähler 13 für die Uhrzeit aufgerufen, der nunmehr auf die eingespeicherte Startzeit gesetzt ist, die im Kästchen 50 der Figur 2 mit $D_P31$ bezeichnet wird und hier gleich der Zeitangabe $D_P22$ ist. Mit einem erneuten Betätigen des Eingabetastschalters E wird die vorgegebene Stopzeit für den ausgewählten Programmwunsch eingestellt und mit einem Betätigen des Auswahltastschalters $W_P$ im Datenwortplatz PI3 der angewählten Programmzeile abgespeichert (Kästchen 51). Gleichzeitig ist mit der Betätigung des Auswahltastschalters $W_P$ der Wortplatzzähler auf den nächsten Zählschritt weitergeschaltet, mit dem er über den Adressbus 22 den letzten Datenwortplatz PI4 der angewählten Programmzeile anwählt und den Wortzähler 12 für das Datum aufruft. Der Wortzähler 12 ist auf das aktuelle Datum gesetzt, das in dem diese Einstellungen veranschaulichenden Kästchen 52 der Figur 2 mit $D_P41$ bezeichnet wird. Dieses Datum wird durch ein weiteres Betätigen des Auswahltastschalters $W_P$ in den Datenwortplatz PI4 der angewählten Programmzeile eingespeichert. Außerdem wird der Wortplatzzähler 8 durch diese Schalterbetätigung in die Überlaufstellung gesetzt, in der er, wie bereits beschrieben, mittels eines Überlaufsignales an seinem Überlaufeingang Ü2 die Umschaltanordnung 18 in die erste Schaltstellung zurückstellt und gleichzeitig sich selbst zurückstellt. Die angewählte Programmzeile ZI1 ist nunmehr programmiert (Kästchen 54).

Das mit der nächsten Betätigung des Auswahltastschalters $W_P$ erzeugte Schaltsignal löst in dem Zeilenadresszähler 7 einen erneuten Suchvorgang nach einer freien Programmzeile aus, die in Figur 2 mit Zl2 (0) bezeichnet ist. Wird für diese Programmzeile der Eingabetastschalter nicht betätigt, sondern abermals der Auswahltastschalter $W_P$ zur sequentiellen Anwahl der nächsten Programmzeile, setzt das dadurch an den Takteingang T1 des Zeilenadresszählers gelangenden Schaltsignals den Zeilenadresszähler auf den Zählschritt für eine Adresse einer programmierten Programmzeile. Bei weiteren Betätigungen des Auswahltastschalters $W_P$ werden sequentiell fortschreitend die übrigen programmierten Programmzeilen über den ersten Adressbus 21 angewählt, bis nach der letzten angewählten programmierten Programmzeile Zln der Zeilenadresszähler in die Überlaufstellung gelangt, in der er, wie bereits beschrieben, mittels eines Überlaufsignales an seinem Überlaufeingang Ü1 die in der Steuerschaltung 1 eingestellte Programmierbetriebseinstellung BE V "Programmwunsch-Programmierung" ausschaltet. Mit einer derartigen Ausschaltung werden gleichzeitig der Zeilenadressenzähler 7, der Wortplatzzähler 8, die Umschaltanordnung 18/19 und die Schaltanordnung 31 an ihren Rückstelleingängen RS rückgestellt oder ausgeschaltet.

In dem in Figur 1 dargestellten Ausführungsbeispiel sind beispielhaft noch weitere zwei Auswahltastschalter dargestellt, ein Auswahltastschalter $W_U$ zur Einstellung einer Programmierbetriebseinstellung der Steuerschaltung 1, in der die Jahresuhr 11 des Datenwortgebers eingestellt werden kann, und ein Auswahltastschalter $W_W$ für eine Betriebseinstellung der Steuerschaltung 1 zur Steuerung des Wiedergabebetriebes des Videogerätes über den zweiten Steuerbus 3. In der Betriebseinstellung "Uhr" der Steuerschaltung 1 ist die Programmzeile Zl-Uhr des Programmspeichers 6 angewählt und der Wortplatzzähler 8 auf eine Zählstellung eingestellt, in der über den zweiten Adressbus 22 der die Uhrzeit enthaltende Datenwortplatz Pl2 der angewählten Programmzeile angewählt und im Datenwortgeber 9 der entsprechende Wortzähler aufgerufen ist. Die Eingabe und Fortschaltung der Programmierung der Uhrzeit und des Datums erfolgt in der gleichen Weise, wie sie für die vorhergehend angegebenen Programmierbetriebseinstellungen der Steuerschaltung 1 beschrieben wurde.

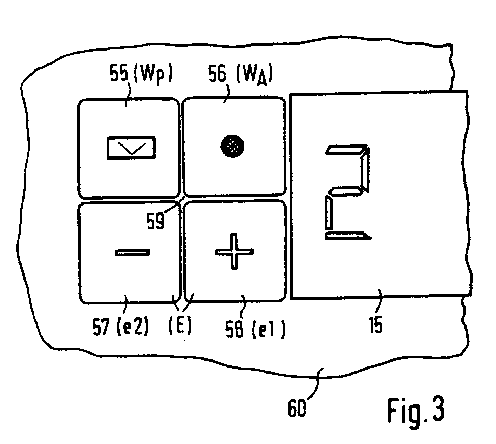

In der Figur 3 ist ein Ausschnitt aus einer Bedienungswand 60 eines Videorecorders dargestellt, auf der neben der Anzeigevorrichtung 15 die wesentlichen für die Programmierung eines Programmwunsches und die Aufnahme dieses Programmwunsches erforderlichen Betätigungselemente 55, 56, 57 und 58 für den Eingabetastschalter E und die beiden Auswahltastschalter $W_P$ und $W_A$ als großflächige Tasten in einem Vierer-Tastenblock so angeordnet sind, daß alle vier Tasten an einer Stelle 59 aneinandergrenzen. Damit wird eine Einhandbedienung erreicht, die eine schnelle Einstellung und Eingabe ermöglicht.

## Ansprüche

1. Empfangs-, Aufnahme- oder Wiedergabeanordnung der Unterhaltungselektronik
   – mit einer Steuerschaltung(1), die in eine Vielzahl unterschiedlicher Betriebseinstellungen einstellbar ist,
   – mit einer Vielzahl von Auswahl- und Eingabetastschaltern zur Auswahl und Einstellung einer dieser Betriebseinstellungen zur sequentiellen Auswahl einer Programmzeile einer der ausgewählten Betriebseinstellung zugeordneten Datenschaltung oder zur sequentiellen Auswahl eines Datenwortplatzes innerhalb der ausgewählten, mehrere aneinandergereihte, auswählbare Datenwortplätze enthaltenden Programmzeile und zur Eingabe von Daten aus einem schrittweise fortschaltbaren Datenwortangebot eines Datenwortgebers in die ausgewählte Programmzeile,
   – und mit einer Anzeigevorrichtung (Display)(15) zur Anzeige der eingestellten Betriebseinstellung der Steuerschaltung, zur Anzeige von Daten der der Betriebseinstellung der Steuerschaltung zugeordneten oder mit einem Auswahltastschalter ausgewählten Programmzeile und zur Anzeige des angewählten Datenwortplatzes innerhalb der neugewählten und angezeigten Programmzeile, **dadurch gekennzeichnet,**
   – daß jeder einstellbaren Betriebseinstellung (BEI ; BEII...) der Steuerschaltung (1) höchstens ein einziger Auswahltastschalter (2) zugeordnet ist,
   – daß die Anordnung einen einzigen Eingabetastschalter (E) zur Eingabe von Daten in die ausgewählte Programmzeile (ZL1) enthält,
   – daß einem Auswahltastschalter ($W_P$ ; $W_A$) für die Einstellung einer solchen Betriebseinstellung (Programmierbetriebseinstellung) der Steuerschaltung, in der Programmzeilen (Zl1 ; Zln) oder Datenwortplätze (Pl1, Pl2) einer Programmzeile (Zl1) programmierbar sind, eine Umschaltanordnung (18) nachgeschaltet ist,
   – daß die Umschaltanordnung in der eingestellten Programmierbetriebseinstellung (BE V) der Steuerschaltung von dieser in eine erste Schaltstellung eingestellt ist, in der sie einen Leitungsweg zwischen dem Ausgang des zugehörigen Auswahltastschalters ($W_P$) und dem ersten Takteingang (T1) für die sequentielle Auswahl der Programmzeilen der der Programmierbetriebseinstellung zugeordneten Datenschaltung (4) bildet,
   – daß die Umschaltanordnung von einem an einen Steuereingang (S 19) der Umschaltanordnung geleiteten Schaltsignal des Ausganges des Eingabetastschalters von der ersten in eine zweite Schaltstellung umgeschaltet ist, in der sie einen Leitungsweg zwischen dem Ausgang des zugehörigen Auswahltastschalters und einem zweiten Takteingang (T2) für die sequentielle Auswahl der Datenwortplätze (PI1) der in der Datenschaltung ausgewählten Programmzeile (ZI1) bildet,

– und daß während der Einstellung der Umschaltanordnung in der zweiten Schaltstellung der Ausgang (25) des Eingabetastschalters mit dem Fortschaltsteuereingang (26) des ausgewählten Programmierbetriebseinstellung der Steuerschaltung zugeordneten Datenwortgebers (9) verbunden ist.

2. Anordnung nach Anspruch 1, dadurch gekennzeichnet, daß der Fortschaltsteuereingang (26) des Datenwortgebers (9) einen Eingang (V) für den Vorwärtslauf und einen Eingang (R) für Rückwärtslauf aufweist und daß der Eingabetastschalter (E) dementsprechend einen Ausgang (e1) für Vorwärtslauf und einen Ausgang (e2) für Rückwärtslauf enthält.

3. Anordnung nach Anspruch 1 oder 2, dadurch gekennzeichnet, daß die Umschaltanordnung (18) in der eingestellten Programmbetriebseinstellung (BE V) der Steuerschaltung (1) von der Rückflanke des Schaltsignales des Auswahltastschalters (Wp), das die Steuerschaltung in die zugehörige Programmbetriebseinstellung einstellt, in die erste Schaltstellung eingestellt ist.

4. Anordnung nach einem der vorhergehenden Ansprüche, dadurch gekennzeichnet,

– daß die Steuerschaltung (1) in der zweiten Schaltstellung der Umschaltanordnung (18) bei jedem Schaltsignal des Ausganges des Auswahltastschalters (Wp), mit dem die zugehörige Programmierbetriebseinstellung (BE V) der Steuerschaltung eingestellt worden ist, vor der Weiterschaltung des Schaltsignals an den zweiten Takteingang (T2) der zugehörigen Datenschaltung ein Einspeichersignal erzeugt und an die Datenschaltung (4) leitet,

– und daß die Datenschaltung bei einem Auftreten des Einspeichersignals das im Datenwortgeber (9) eingestellte Datenwort in den angewählten Datenwortplatz (PI2) der angewählten Programmzeile (ZI1) einspeichert.

5. Anordnung nach einem der vorhergehenden Ansprüche, dadurch gekennzeichnet, daß in der Einstellung der Datenschaltung (4) auf den letzten anwählbaren Datenwortplatz (PI4) einer angewählten Programmzeile (ZI1) die Rückflanke eines Schaltsignals am zweiten Takteingang (T2) der Datenschaltung in dieser ein Überlaufsignal auslöst, das den Wortplatzzähler (8) zur Auswahl der Datenwortplätze in der Datenschaltung rückstellt und das der Umschaltanordnung (18, 19) zugeführt ist und diese in die erste Schaltstellung zurückstellt.

6. Anordnung nach einem der vorhergehenden Ansprüche, dadurch gekennzeichnet, daß in der Einstellung der Datenschaltung (4) auf die letzte anwählbare Programmzeile (ZIn) einer Zeilenfolge die Rückflanke eines Schaltsignals am ersten Takteingang (T1) der Datenschaltung in dieser ein zweites Überlaufsignal auslöst, das den eingestellten Programmierbetriebszustand der Steuerschaltung (1) ausschaltet.

7. Anordnung nach einem der vorhergehenden Ansprüche, gekennzeichnet durch eine Zeitschaltanordnung (17), die an den Ausgang der Auswahltastschalter (2) für eine Programmierbetriebseinstellung der Steuerschaltung (1) und in einer eingeschalteten Programmierbetriebseinstellung der Steuerschaltung an den Ausgang des Eingabetastschalters (E) angeschlossen ist und bei einem Ausgangssignal dieser Tastschalter nach einer vorbestimmten Zeit ein Schaltsignal erzeugt,das den Programmierbetriebszustand der Steuerschaltung ausschaltet.

8. Anordnung nach einem der vorhergehenden Ansprüche, dadurch gekennzeichnet, daß die während einer Programmierbetriebseinstellung (BE V) der Steuerschaltung (1) an die Datenschaltung (4) angeschlossene Anzeigeanordnung (15) den Programmierzustand der angewählten Programmzeile (ZI1) der Datenschaltung vollständig anzeigt.

9. Anordnung nach einem der vorhergehenden Ansprüche, dadurch gekennzeichnet, daß die Tasten (55 bis 58) der Auswahltastschalter (2) für die Aufnahmebetriebseinstellung (BE III) und für die Aufnahmewunschprogrammierung (BE V) und für den Eingabetastschalter (E) großflächig ausgebildet sind und sämtliche dieser Tasten aneinander grenzen.

## Claims

1. Reception recording or reproduction configuration for consumer electronics

– with a control circuit (1) which can be set to a plurality of different operating modes,

– with a plurality of selector and entry momentary-contact switches for selecting and setting one of these operating modes, for sequential selection of a program line of a data circuit assigned to the selected operating mode or for sequential selection of a data word location within the selected program line containing several selectable data word locations in a string and for entering data into the selected program line out of a series of data words offered by a steppable data word generator,

– and with a display (15) for displaying the set operating mode of the control circuit for displaying data of the program line assigned to the operating mode of the control circuit or selected with a selector momentary-contact switch, and for displaying the selected data word location within the newly selected and displayed program line, characterized in

– that maximally a single selector momentary-contact switch (2) is assigned to each settable operating mode (BEl BEll...) of the control circuit (1),

– that the configuration contains a single entry momentarycontact switch (E) for entering data into the selected program line (Z11),

– that a switchover configuration (18) is installed behind a selector momentary-contact switch ($W_p$; $W_A$) for setting such an operating mode (programming mode setting) of the control circuit, in which program lines (Z11 ; Z1n) or data word locations (p11 ; p12) of a program line (Z11) can be programmed,

– that the switchover configuration in the set programming mode setting (BE V) of the control circuit is set by this into a first operating position in which it forms a conductor path between the output of the associated selector momentarycontact switch ($W_p$) and the first clock input (T1) for the sequential selection of the program lines of the data circuit (4) assigned to the programming mode setting,

– that the switchover configuration is switched over from the first to a second operating position by a switching signal fed to a control input (S 19) of the switchover configuration from the output of the entry momentary-contact switch, thus forming a conductor path between the output of the associated selector momentary-contact switch and a second clock input (T2) for the sequential selection of the data word locations (P11) of the program line (Z11) selected in the data circuit,

– and that while the switchover configuration is set to its second operating position, the output (25) of the entry momentary-contact switch is connected to the stepping control input (26) of the data word generator (9) assigned to the selected programming mode setting of the control circuit.

2. Configuration in accordance with Claim 1 characterized in that the stepping control input (26) of the data word generator (9) exhibits an input (V) for forward running and an input (R) for reverse running and that the entry momentary-contact switch (E) correspondingly contains an output (e1) for forward running and an output (e2) for reverse running.

3. Configuration in accordance with Claim 1 or 2, characterized in that the switchover configuration (18), when set to the programming mode setting (BE V) of the control circuit (1), is set to its first operating position by the trailing edge of the switching signal of the selector momentary-contact switch ($W_p$), which sets the control circuit to the associated programming mode setting.

4. Configuration in accordance with one of the preceding claims, characterized in

– that the control circuit (1) in the second operating position of the switchover configuration (18), at every switching signal from the output of the selector momentary-contact switch ($W_p$) with which the associated programming mode setting (BE V) of the control circuit has been set, before transferring the switching signal to the second clock input (T2) of the associated data circuit generates a read-in signal and passes this latter signal to the data circuit (4),

– and that the data circuit when, the read-in signal occurs, reads the data word set in the data word generator (9) into the selected data word location (P12) of the selected program line Z11).

5. Configuration in accordance with one of the preceding claims, characterized in that when the data circuit (4) is set to the last selectable data word location (P14) of a selected program line (Z11) the trailing edge of a switching signal at the second clock input (T2) of the data circuit triggers an overflow signal in the latter, which resets the word location counter (8) for selecting the data word locations in the data circuit, and which is fed to the switchover configuration (18, 19) and resets this to its first operating position.

6. Configuration in accordance with one of the preceding claims characterized in that when the data circuit (4) is set to the last selectable data program line (Z1n) of a line sequence, the trailing edge of a switching signal at the first clock input (T1) of the data circuit triggers a second overflow signal in the latter, which switches off the set programming mode status of the control circuit (1).

7. Configuration in accordance with one of the preceding claims, characterized by a timing configuration (17), which is connected to the output of the selector momentary-contact switches (2) for a programming mode setting of the control circuit (1) and (in a switched-on programming mode setting of the control circuit) to the output of the entry momentary-contact switch (E), and in the event of an output signal from these momentary- contact switches, will after a predefined time generate a switching signal which switches off the programming mode status of the control circuit.

8. Configuration in accordance with one of the preceding claims, characterized in that the display configuration (15) connected to the data circuit (4) during a programming mode setting (BE V) of the control circuit (1) provides a complete display of the programming status of the selected program line (Z11) of the data circuit.

9. Configuration in accordance with one of the preceding claims, characterized in that the buttons (55 to 58) of the selector momentary-contact switches (2) for setting recording mode (BE) and for programming recording wishes (BE III) and for the entry momentary-contact switch (E) are large size designed, and all of these buttons adjoin each other.

## Revendications

1. Dispositif de réception d'enregistrement ou de lecture de l'électronique grand public
   – équipé d'un circuit de commande (1) pouvant être ajusté sur une multitude de réglages fonctionnels différents,
   – équipé d'une multitude de touches de sélection et d'introduction pour sélectionner et ajuster l'un de ces réglages fonctionnels pour sélectionner de façon séquentielle une ligne de programme d'un circuit de données attribué au réglage fonctionnel sélectionné
   ou pour sélectionner de façon séquentielle un emplacement de mot de données au sein de la ligne de programme sélectionnée contenant plusieurs emplacements de mot de données enchaînés et sélectionnables et pour entrer, dans une ligne de programme sélectionnée, des données à partir d'une réserve de mots de données avançable par pas d'un générateur de mots de données,
   – et équipé d'un dispositif d'indication (affichage) (15) destiné à indiquer le réglage fonctionnel ajusté du circuit de commande, à indiquer les données de la ligne de programme assignée au réglage fonctionnel du circuit de commande ou sélectionnée au moyen d'une touche de sélection et à indiquer l'emplacement de mot de données sélectionné au sein de la ligne de programme nouvellement sélectionnée et affichée,
   caractérisé en ce
   – qu'au maximum une seule touche de sélection (2) est assignée à chaque réglage fonctionnel ajustable (BEI ; BEII...) du circuit de commande (1),
   – que le dispositif comporte une seule touche d'introduction (E) pour l'entrée de données dans la ligne de programme sélectionnée (ZL1),
   – qu'un dispositif de commutation (18) est monté en aval d'une touche de sélection (W$_p$ ; W$_A$) servant à ajuster un tel réglage fonctionnel (réglage fonctionnel de programmation) du circuit de commande permettant de programmer des lignes de programme (ZL1 ; ZLn) ou des emplacements de mots de données (PL1 ; PL2) d'une ligne de programme (PL1),
   – que le dispositif de commutation est ajusté dans le réglage fonctionnel de programmation ajusté (BE V) du circuit de commande, par celui-ci sur une première position de commutation dans laquelle il forme un parcours de ligne entre la sortie de la touche de sélection (W$_p$) et la première entrée de cycle (T1) pour la sélection séquentielle des lignes de programme du circuit de données (4) affecté au réglage fonctionnel de programmation,
   – que le dispositif de commutation est commuté, par un signal de commutation délivré par la sortie de la touche d'introduction et appliqué à l'entrée de commande (S 19) du dispositif de commutation, de la première sur la deuxième position de commutation dans laquelle elle forme un parcours de ligne entre la sortie de la touche de sélection correspondante et une deuxième entrée de cycle (T2) pour la sélection séquentielle des emplacements de mots de données (PL1) de la ligne de programme (PL1) sélectionnée dans le circuit de données
   – et qu'au cours du réglage du dispositif de commutation sur la deuxième position de commutation, la sortie (25) de la touche d'introduction est reliée à l'entrée de commande d'avancement (26) du générateur de mots de données (9) assigné au réglage fonctionnel de programmation sélectionné du circuit de commande.

2. Dispositif selon la revendication 1, caractérisé en ce que l'entrée de commande d'avancement (26) du générateur de mots de données (9) dispose d'une entrée (V) pour la marche avant et une entrée (R) pour la marche arrière et que la touche d'introduction (E) contient ainsi une sortie (e1) pour la marche avant et une sortie (e2) pour la marche arrière.

3. Dispositif selon la revendication 1 ou 2, caractérisé en ce que le dispositif de commutation (18), dans le réglage fonctionnel de programmation (BE V) ajusté du circuit de commande (1) est commuté sur la première position de commutation par le flanc arrière du signal de commutation de la touche de sélection (W$_p$) qui ajuste le circuit de commande sur le réglage fonctionnel de programmation correspondant.

4. Dispositif selon l'une des revendications ci-dessus, caractérisé en ce
   – que le circuit de commande (1) sur la deuxième position de commutation du dispositif de commutation (18) génère et délivre un signal de mémorisation au circuit de données (4) à chaque fois qu'il y a délivrance d'un signal de commutation de la sortie de la touche de sélection (W$_P$) au moyen de laquelle le réglage fonctionnel de programmation (BE V) correspondant du circuit de commande a été ajusté, avant d'appliquer le signal de commutation à la deuxième entrée de cycle (T2) du circuit de données y afférent
   – et que le circuit de données mémorise, dès l'apparition du signal de mémorisation, le mot de données ajusté dans le générateur de mots de données (9) dans l'emplacement de mot de données (PL2) de la ligne de programme (ZL1) sélectionnée.

5. Dispositif selon l'une des revendications ci-dessus, caractérisé en ce que, dans le cas du réglage du circuit de données (4) sur le dernier emplacement de mot de données (PL4) sélectionnable d'une ligne de programme (ZL1) sélectionnée, le flanc arrière d'un signal de commutation appliqué à la deuxième entrée de cycle (T2) du circuit de données déclenche dans ce dernier un signal de débordement qui remet à zéro le compteur d'emplacements de mots (8) pour la sélection des emplacements de mots de données dans le circuit de données et qui est appliqué au dispositif de commutation (18, 19) pour remettre celui-ci sur sa première position de commutation.

6. Dispositif selon l'une des revendications ci-dessus, caractérisé en ce que, dans le cas du réglage du circuit de données (4) sur la dernière ligne de programme sélectionnable (ZLn) d'une suite de lignes, le flanc arrière d'un signal de commutation appliqué à la première entrée de cycle (T1) du circuit de données déclenche dans ce dernier un deuxième signal de débordement qui met hors circuit le mode de programmation ajusté du circuit de commutation (1).

7. Dispositif selon l'une des revendications ci-dessus, caractérisé en ce qu'un dispositif à minuterie (17) est raccordé à la sortie de la touche de sélection (2) pour un réglage fonctionnel de programmation du circuit de commande (1) et, dans le cas d'un réglage fonctionnel de programmation ajusté du circuit de commande à la sortie de la touche, d'introduction (E) et qu'en présence d'un signal de sortie, cette touche génère après un laps de temps prédéterminé un signal de commutation désactivant le mode de programmation du circuit de commande.

8. Dispositif selon l'une des revendications ci-dessus, caractérisé en ce que le dispositif d'indication (15) raccordé au circuit de données (4) au cours d'un réglage fonctionnel de programmation (BE V) du circuit de commande (1) affiche entièrement l'état de programmation de la ligne de programme sélectionnée (ZL1) du circuit de données.

9. Dispositif selon l'une des revendications ci-dessus, caractérisé en ce que les boutons (55 à 58) des touches de sélection (2) pour le réglage du mode d'enregistrement (BE III) et pour la programmation des souhaits d'enregistrement (BE V) ainsi que pour la touche d'introduction (E) sont largement dimensionnés et que toutes les touches sont contigues.

Fig.1

Fig.2

BE I : Stand by — 28

$W_A$ — 37

BE II : Stop — 30

$W_A$

38

BE III : Aufnahme

$W_A$

| ZI·A | E | PI 3 (DA 31) | E | PI 3 (DA 32) |

42

$W_A$

BE IV : Stopzeit

PI 3 DA 32 — 43

39

$W_p$ — 45

46

| ZI 1(0) | E | PI 1 (Dp 11) | E | PI 1 (Dp 12) |

47

$W_p$

PI 1 Dp 12 — 48

PI 2 (Dp 21) — 49 | E | PI 2 (Dp 22)

$W_p$

PI 2 Dp 22

50 — PI 3 (Dp 31) | E | PI 3 (Dp 32)

BE V : „Programmwunsch-
Programmierung"

$W_p$

51 — PI 3 Dp 32

52 — PI 4 (Dp 41)

$W_p$

PI 4 Dp 41

ZI 1 — 54

$W_p$

ZI 2 (0)

$W_p$

$W_p$

ZI n

$W_p$

12

Fig.3